# EUROPEAN PATENT APPLICATION

(11) **EP 2 846 074 A1**
(43) Date of publication of application: **11.03.2015**
(21) Application number: 14182614.9
(22) Date of filing: 28.08.2014
(51) Int. Cl.: F21S 4/00, F21V 23/06, H01L 33/54, H01L 33/62

(54) **Lighting device having omnidirectional lighting unit and method for manufacturing omnidirectional lighting unit**

(30) Priority: 06.09.2013 TW 102132147
(71) Applicant: Lextar Electronics Corp., 30075 Hsinchu (TW)
(72) Inventor: Chiu, Kuan-Yu, Zhongli City 320 Taoyuan County (TW)
(74) Representative: Fuchs Patentanwälte Partnerschaft mbB

(57) **Abstract**

Embodiments of a lighting device are disclosed. The light device includes an omnidirectional lighting unit including a light-emitting chip, a spherical package member, a diffusion layer, and two conductive structures. The light-emitting chip has a positive electrode and a negative electrode. The spherical package member encapsulates the light-emitting chip, and the diffusion layer covers an outer surface of the spherical package member. The two conductive structures are electrically connected to the positive and negative electrodes, respectively, and each of the two conductive structures penetrates through the spherical package member and the diffusion layer outwardly, such that a portion of each conductive structure is exposed the exterior of the diffusion layer.

## Description

### CROSS REFERENCE TO RELATED APPLICATIONS

This Application claims priority of Taiwan Patent Application No. 102132147, filed on September 6, 2013, the entirety of which is incorporated by reference herein.

### BACKGROUND OF THE INVENTION

### Field of the Invention

The present invention relates to a lighting unit and a lighting device using the lighting unit and a manufacturing method of the lighting unit, and more particularly to an omnidirectional lighting unit and a lighting device using the omnidirectional light unit and a manufacturing method of the omnidirectional lighting unit.

### Description of the Related Art

With the development of lighting technology, varied new lighting elements are available. For example, LED (light-emitting diodes), halogen lamps and laser diodes are new lighting elements.

In general, the LED can be used in various types of lamp structures, such as the light bulb or the tubular lamp to provide illumination. The light emitted by the LED is radiated outwardly and passing through the cover of the light bulb or the tubular lamp to generate light on the front side direction thereof. Since the light emitting angle of the LED is less than 180 degrees, the light emitting angle of the LED light source is not satisfactory as compared with a conventional incandescent light source.

Consequently, the conventional LED needs to be further improved in terms of light emitting angle and luminous uniformity.

### BRIEF SUMMARY OF THE INVENTION

One objective of the present invention is to provide a lighting unit with at least one light-emitting chip that is packaged by a spherical package member so as to provide an omnidirectional illumination.

According to some embodiments of the disclosure, the omnidirectional lighting unit includes a light-emitting chip, a spherical package member, a diffusion layer, and two conductive structures. The light-emitting chip has a positive electrode and a negative electrode. The spherical package member encapsulates the light-emitting chip, and the diffusion layer covers an outer surface of the spherical package member. The two conductive structures are electrically connected to the positive and negative electrodes, respectively. Each of the two conductive structures outwardly penetrates through the spherical package member and the diffusion layer, and a portion of each conductive structure is exposed to the exterior of the diffusion layer.

In some embodiments, each of the two conductive structures includes a conducting wire and a conductive terminal connected to the conducting wire. The conducting wires are electrically connected to the light-emitting chip. The conductive terminals outwardly penetrate through the package member and the diffusion layer, and a portion of each conductive terminal is exposed to the exterior of the diffusion layer.

In some embodiments, the two conductive structures are conducting wires. Alternatively, each of the conductive structures includes a conducting wire and a conductive terminal.

In some embodiments, the lighting unit further includes a wavelength conversion layer covering the outer surface of the diffusion layer. The diffusion layer includes light diffusion particles. The light diffusion particles are selected from a group consisting of silicon dioxide and titanium dioxide.

In some embodiments, the lighting unit further includes a protection layer covering the outer surface of the wavelength conversion layer. The protection layer includes at least two regions, each with a refractive index that is different from the other. The material of the protection layer is selected from a group consisting of epoxy resin, silicon resin, and acrylic resin.

In some embodiments, the light-emitting chip is an LED chip. In addition, the material of the spherical package member is selected from a group consisting of epoxy resin, silicon resin, and acrylic resin.

Another objective of the present invention is to provide a lighting device using any lighting unit in any of the embodiments mentioned above. The light unit includes N omnidirectional lighting units, where N is a natural number greater than or equal to 2. The light unit further includes N-1 connector(s) respectively between the omnidirectional lighting units and electrically connected to two of the omnidirectional lighting units neighboring to thereof.

Still another objective of the present invention is to provide a method to manufacture an omnidirectional lighting unit. According to some embodiments of the invention, the method to manufacture the omnidirectional lighting unit includes providing a light-emitting chip with a positive electrode and a negative electrode. The method also includes forming two conductive structures on the light-emitting chip. The two conductive structures are respectively electrically connected to the positive electrode and the negative electrode. The method further includes forming a first semi-spherical package member to encapsulate the upper surface of the light-emitting chip and a portion of the upper surface of the two conductive structures. In addition, the method includes forming a second semi-spherical package member to encapsulate the lower surface of the light-emitting chip and a portion of the lower surface of the two conductive structures so as to cooperatively form a spherical package member with the first semi-spherical package member.

Specifically, the operation of forming the first semi-spherical package member and the second semi-spherical package member includes providing a carrier to support the light-emitting chip; providing a first mold arranged on the carrier, wherein the first mold has a first mold cavity which covers the upper surface of the light-emitting chip and a portion of the upper surface of each conductive structure therein; injecting a first encapsulant material into the first mold cavity; removing the carrier; providing a second mold, wherein the second mold has a second mold cavity which covers the lower surface of the light-emitting chip and a portion of the lower surface of each conductive structure therein; injecting a second encapsulant material into the second mold cavity; curing the first encapsulant material and the second encapsulant material ; and removing the first mold and the second mold to complete the first and second semi-spherical package members.

In some embodiments, the method further includes forming a diffusion layer to cover the outer surface of the spherical package member, forming a wavelength conversion layer to cover the outer surface of the diffusion layer, and forming a protection layer to cover the outer surface of the wavelength conversion layer.

In some embodiments, the two conductive structures are conducting wires. Alternatively, each of the conductive structures includes a conducting wire and a conductive terminal.

The light-emitting chip is surrounded by a spherical package member cooperatively formed by two semi-spherical package members. The light-emitting chip is not supported by a substrate or encapsulated by a package member that blocks light passing therethrough. Therefore, light emitted from the light-emitting chip is able to be radiated omnidirectionally.

### BRIEF DESCRIPTION OF THE DRAWINGS

The invention can be more fully understood by reading the subsequent detailed description and examples with references made to the accompanying drawings.
FIG. 1 shows a cross-sectional view of an omnidirectional lighting unit, in accordance with some embodiments.
FIG. 2 shows a cross-sectional view of an omnidirectional lighting unit, in accordance with some embodiments.
FIG. 3 shows a schematic view of a lighting device, in accordance with some embodiments.
FIGs. 4A-4H show a method for manufacturing an omnidirectional lighting unit, in accordance with some embodiments.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

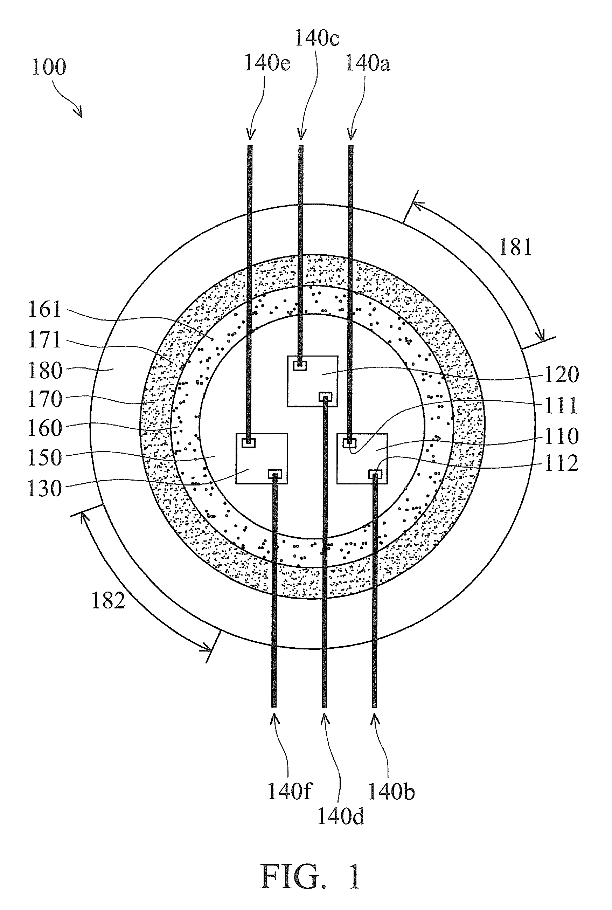

Referring to FIG. 1, an omnidirectional lighting unit 100 includes a number of light-emitting chips, such as light-emitting chips 110, 120, and 130, a number of conductive structures, such as conductive structures 140a-140f, and a package member 150, in accordance with some embodiments.

The light-emitting chips 110, 120, and 130 are located on the same plane. The light-emitting chips 110, 120, and 130 are separated by a distance and not connected to each other to prevent light emitted from the neighboring light-emitting chips being absorbed by the others. However, the disclosure should not be limited thereto. In some embodiments, the light-emitting chips 110, 120, and 130 are spaced at different distances. In some other embodiments, the number of light-emitting chips is varied according to demand.

In some embodiments, the light-emitting chips 110, 120, and 130 are LED chips (Light Emitting Diode chips) which emit light with different wavelengths. For example, the light-emitting chip 110 emits blue light, the light-emitting chip 120 emits red light, and the light-emitting chip 130 emits green light. However, the disclosure should not be limited thereto. In some embodiments, all of the light-emitting chips 110, 120, and 130 emit light with the same wavelength.

In some embodiments, each of the light-emitting chips 110, 120, and 130 has a positive electrode 111 and a negative electrode 112. For example, the light-emitting chip 110 has a positive electrode 111 and a negative electrode 112 formed on a single surface of the light-emitting chip 110. Each of the conductive structures 140a-140f is a conducting wire (e.g., gold line). The conductive structure 140a and the conductive structure 140b are respectively electrically connected to the positive electrode 111 and the negative electrode 112 of the light-emitting chip 110. The conductive structure 140c and the conductive structure 140d are respectively electrically connected to a positive electrode and a negative electrode of the light-emitting chip 120. In addition, the conductive structure 140e and the conductive structure 140f are respectively electrically connected to a positive electrode and a negative electrode of the light-emitting chip 130. In some embodiments, each negative electrode and each positive electrode of the light-emitting chips 110, 120, and 130 are not only connected to a single conductive structure but connected to two or more conductive structures. In some other embodiments, each single conductive structure includes two conductive wires commonly connected to one positive electrode or one negative electrode of the light-emitting chips 110, 120, and 130.

The shape of the package member 150 is spherical. The package member 150 encapsulates the light-emitting chips 110, 120, and 130 and a portion of the conductive structures 140a-140f The package member 150 is transparent. The material of the package member 150 is selected from a group consisting of epoxy resin, silicon resin, and acrylic resin.

In some embodiments, the omnidirectional lighting unit 100 further includes a diffusion layer 160. The diffusion layer 160 for diffusing light is configured to increase the uniformity of light emitted from the light-emitting chips 110, 120, and 130. As shown in FIG. 1. the diffusion layer 160 includes diffusion particles 161 dispersed in the diffusion layer 160. The diffusion particles 161 are selected from a group consisting of silver, resin, silicon (e.g., silicon dioxide and titanium dioxide), and other white compounds for scattering and mixing lights. Red light, blue light, and green light are mixed to produce white light in the diffusion layer 160 after hitting the diffusion particles 161. Therefore, a light intensity reduction due to shielding effect is restrained.

In some embodiments, the omnidirectional lighting unit 100 further includes a wavelength conversion layer 170 covering the outer surface of the diffusion layer 160 by suitable means, such as coating. The wavelength conversion layer 170 includes wavelength conversion material 171, such as a phosphor powder, quantum dot or organic emitting material, for converting a light emitted from each light-emitting chip 110, 120, and 130 into a light with desirable wavelength. In some other embodiments, the wavelength conversion material 171, including yellow phosphor (such as YAG), and a yellow light is obtained by a blue light emitted by the light-emitting chips 110, 120, or 130 exciting yellow phosphor.

In some embodiments, the omnidirectional lighting unit 100 further includes a protection layer 180 covering the outer surface of the wavelength conversion layer 170 by suitable means, such as coating. The protection layer 180 is configured to protect the wavelength conversion layer 170. The material of the protection layer 180 is selected from a group consisting of epoxy resin, silicon resin, and acrylic resin. As shown in FIG. 1, the protection layer 180 includes multiple regions 181 and 182, each with a refractive index different from the other. With these arrangements, light passing through the protection layer 180 is affected by different refractive indexes, and a particular illumination purpose is achieved.

It is appreciated that the wavelength conversion layer 170 and the protection layer 180 are not an essential elements of the disclosure. In some embodiments, either the wavelength conversion layer 170 or the protection layer 180 is omitted. In some other embodiments, the omnidirectional lighting unit 100 includes two different wavelength conversion layers 170 sequentially arranged, so as to create particular optical effect.

It should be noted that no matter whether the omnidirectional lighting unit 100 includes the diffusion layer 160, the wavelength conversion layer 170, and/or the protection layer 180, the end portion of each of the conductive structures 140a-140f is not completely covered by the diffusion layer 160, the wavelength conversion layer 170, and/or the protection layer 180. Each of the conductive structures 140a-140f outwardly penetrates through the diffusion layer 160, the wavelength conversion layer 170, and/or the protection layer 180. The end portion of each of the conductive structures 140a-140f is located at the outermost portion of the omnidirectional lighting unit 100 and is exposed to the exterior of the protection layer 180.

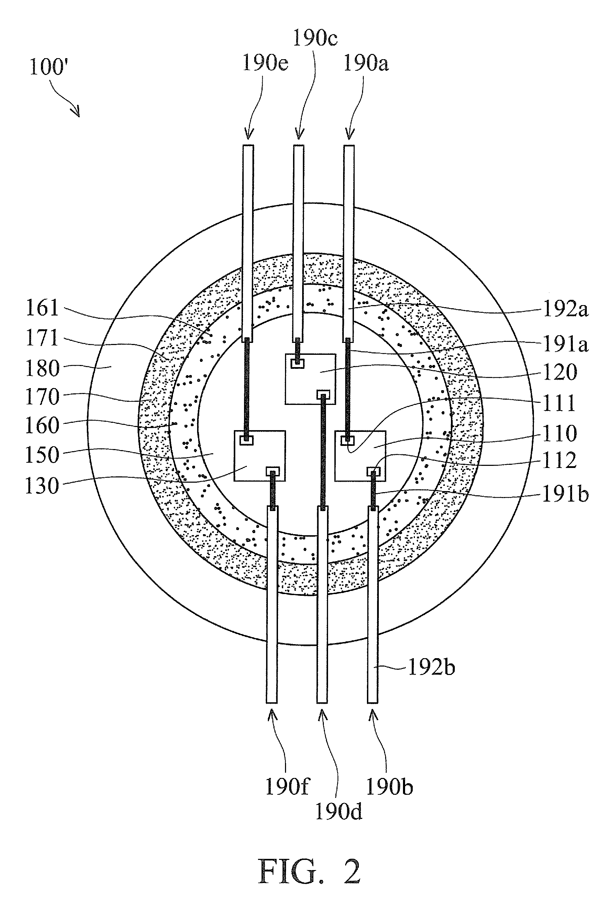

FIG. 2 shows a cross-sectional view of an omnidirectional lighting unit 100' in accordance with some embodiments. Since elements similar to those of the omnidirectional lighting unit 100 shown in FIG. 1 are provided with the same reference numbers, the features thereof are not reiterated in the interest of brevity. In the embodiments, the conductive structures 140a-140f of the omnidirectional lighting unit 100 is replaced by conductive structures 190a-190f. Each of the conductive structures 190a-190f includes a conductive wire (e.g., gold wire) and a conductive terminal connected to the conductive wire. The conductive wires are electrically connected to the light-emitting chips and encapsulated by the package member 150. The conductive terminals outwardly penetrate through the diffusion layer 160, the wavelength conversion layer 170, and the protection layer 180. The end portion of each conductive terminal is the outermost portion of the omnidirectional lighting unit 100' and is exposed to the exterior of the protection layer 180 for connecting an external circuit.

For example, in the embodiment, the conductive structure 190a includes a conductive wire 191 a and a conductive terminal 192a. The conductive wire 191 a is electrically connected to the positive electrode 111 of the light-emitting chip 110 and encapsulated by the package member 150. The conductive terminal 192a outwardly penetrates through the diffusion layer 160, the wavelength conversion layer 170, and the protection layer 180. The end portion of the conductive terminal 192a is the outermost portion of the omnidirectional lighting unit 100' and is exposed to the exterior of the protection layer 180. Similarly, the conductive structure 190b includes a conductive wire 191b and a conductive terminal 192b. The conductive wire 191b is electrically connected to the negative electrode 112 of the light-emitting chip 110 encapsulated by the package member 150. The conductive terminal 192b outwardly penetrates through the diffusion layer 160, the wavelength conversion layer 170, and the protection layer 180. The end portion of conductive terminal 192b is exposed to the exterior of the protection layer 180. The conductive structures 190c, 190d, 190e, and 190f are connected to the light-emitting chips 120 and 130 by a similar method. For brevity of the specification, the description about the connections of the conductive structures 190c, 190d, 190e, and 190f to the light-emitting chips 120 and 130 are omitted.

In some embodiments, since the stiffness of the conductive structures 190a-f is higher than that of the wires, after the package process of the omnidirectional lighting unit 100', the conductive structures 190a-190f facilitate the electrical connection of the omnidirectional lighting unit 100' to an external circuit. Therefore, the stability of the omnidirectional lighting unit 100' is enhanced.

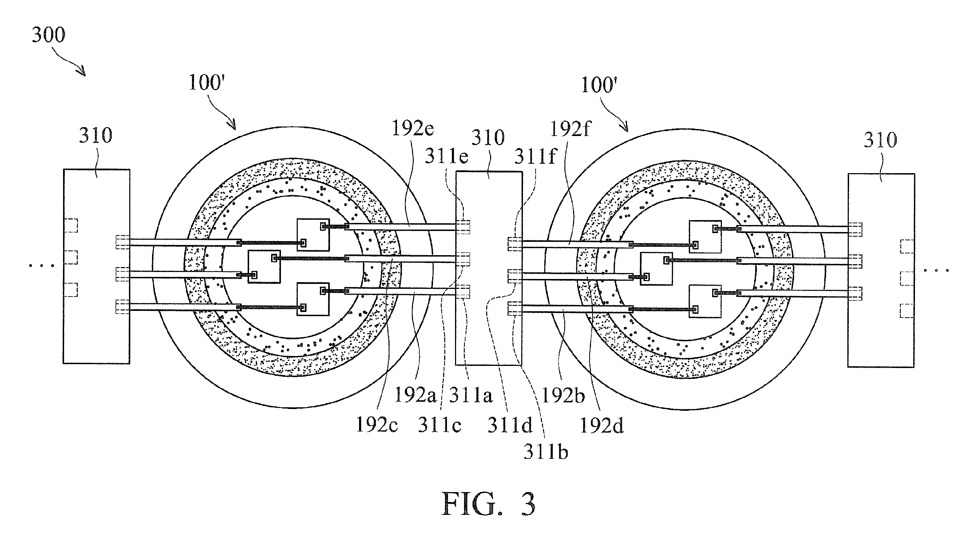

FIG. 3 shows a schematic view of a lighting device 300 using the omnidirectional lighting unit 100' in accordance with some embodiments. The lighting device 300 includes a number of omnidirectional lighting units 100' and a number of electrical connectors 310. In some embodiments, each electrical connector 310 includes a number of receptacles 311a-311f. The receptacle 311a is electrically connected to the receptacle 311b. The receptacle 311c is electrically connected to the receptacle 311d. The receptacle 311e is electrically connected to the receptacle 311f. Each of the receptacles 311a-311f corresponds to one of the conductive terminals 192a-192f.

To electrically connect two omnidirectional lighting units 100', the lighting device 300 is placed between the two omnidirectional lighting units 100'. The conductive terminals 192a, 192c, and 192e of one of the two omnidirectional lighting units 100' are respectively inserted into the receptacles 311 a, 311c, and 311e, and the conductive terminals 192b, 192d, and 192f of the other omnidirectional lighting units 100' are respectively inserted into the receptacles 311 b, 311d, and 311f In some other embodiments, the conductive terminals 192a-192f of the omnidirectional lighting units 100' are electrically connected to a power source rather than another omnidirectional lighting unit 100'.

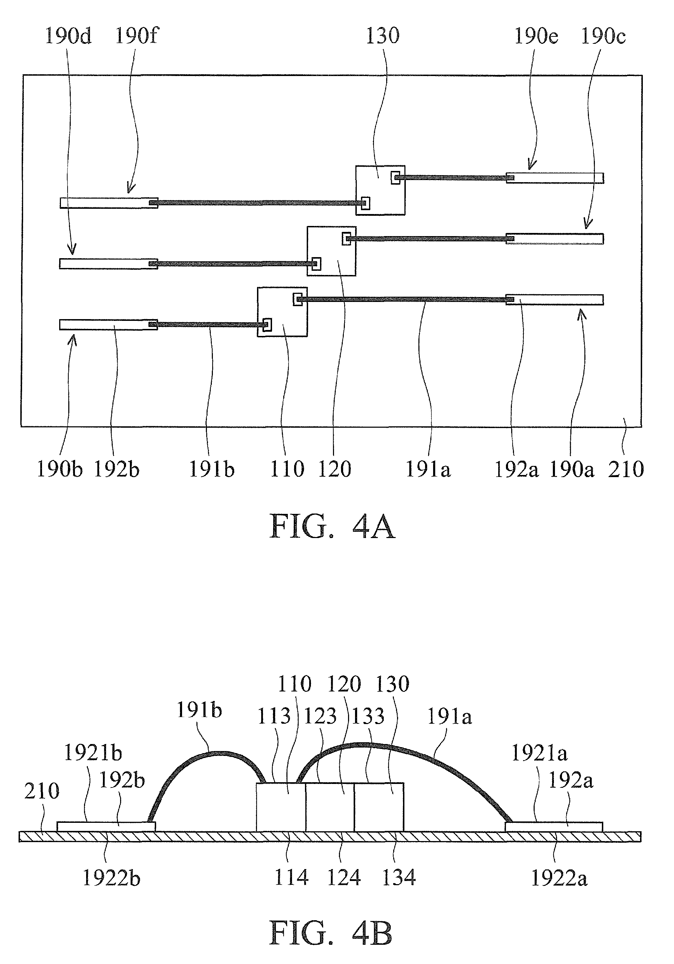

Referring to FIGs. 4A-4H, the method for packaging the light-emitting chips 110, 120, and 130 and the conductive structures 140a-140f (FIG. 1) by the package member 150 (FIG. ) is described hereinafter, in accordance with some embodiments. It should be noted that, in some embodiments, since the method for packaging the conductive structures 140a-140f is similar to the method for encapsulating the conductive structures 190a-190f. For brevity, only the method for encapsulating the conductive structures 190a-190f is described in the following descriptions.

As shown in FIG. 4A, a carrier 210 is provided, and the light-emitting chips 110, 120, and 130 and the conductive members 190a-190f are supported by the carrier 210, wherein the positive electrode and the negative electrode of the light-emitting chips 110, 120, and 130 are electrically connected to the conductive members 190a-190f. As shown in FIG. 4B (the conductive structures 190c-190f are not shown in FIG. 4B), the light-emitting chips 110, 120, and 130 are mounted on the carrier 210 via the bottom surfaces 114, 124, and 134 thereof, and the conductive structures 190a and 190b are connected to the carrier 210 via the bottom surfaces 1922a and 1922b thereof

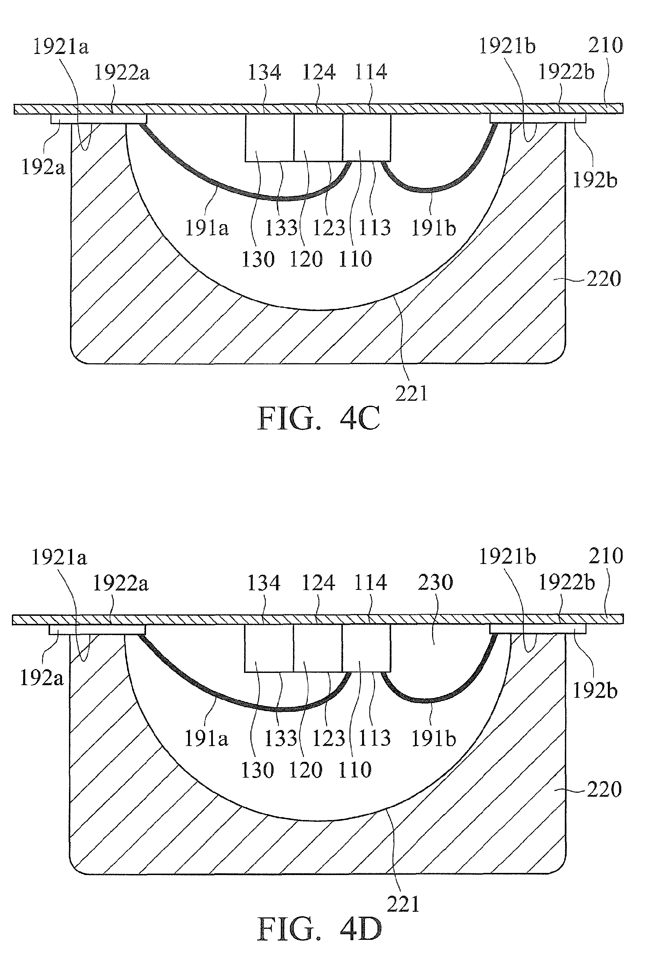

Afterwards, as shown in FIG. 4C (the conductive structures 190c-190f are not shown in FIG. 4C), a first mold 220 is provided on the carrier 210. The first mold 220 has a first mold cavity 221. The upper surfaces 113, 123, and 133 of the light-emitting chips 110, 120, and 130 and the upper surface 1921a and 1921b of the conductive structures 192a and 192b are covered by the first mold cavity 221. Afterwards, as shown in FIG. 4D (the conductive structures 190c-190f are not shown in FIG. 4D), a first encapsulant material 230 is injected into the first mold cavity 221. Therefore, the light-emitting chips 110, 120, and 130, the conductive wires 191a and 191b, and a portion of each of the conductive structures 192a and 192b are packaged by the first encapsulant material 230.

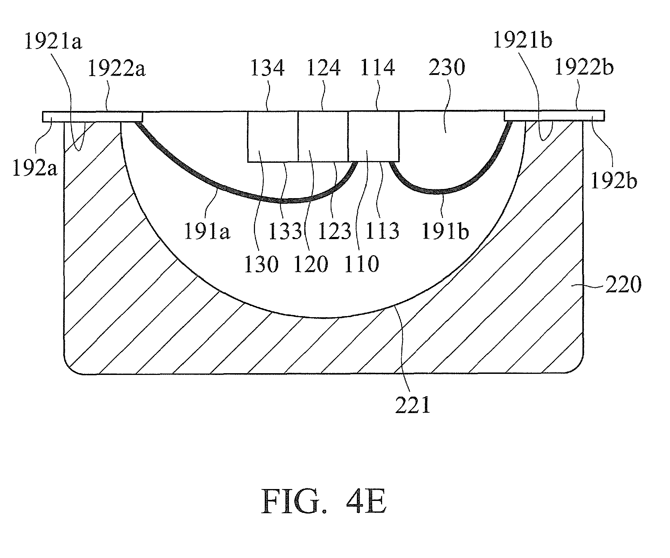

Referring to FIG. 4E (the conductive structures 190c-190f are not shown in FIG. 4E), after the injection of the first encapsulant material 230, the carrier 210 is removed from the light-emitting chips 110, 120, and 130 and the conductive structures 192a and 192b. At this time, the bottom surfaces 114, 124, and 134 of the light-emitting chips 110, 120, and 130 and the bottom surfaces 1922a and 1922b of the conductive structures 192a and 192b are exposed the exterior of the first encapsulant material 230.

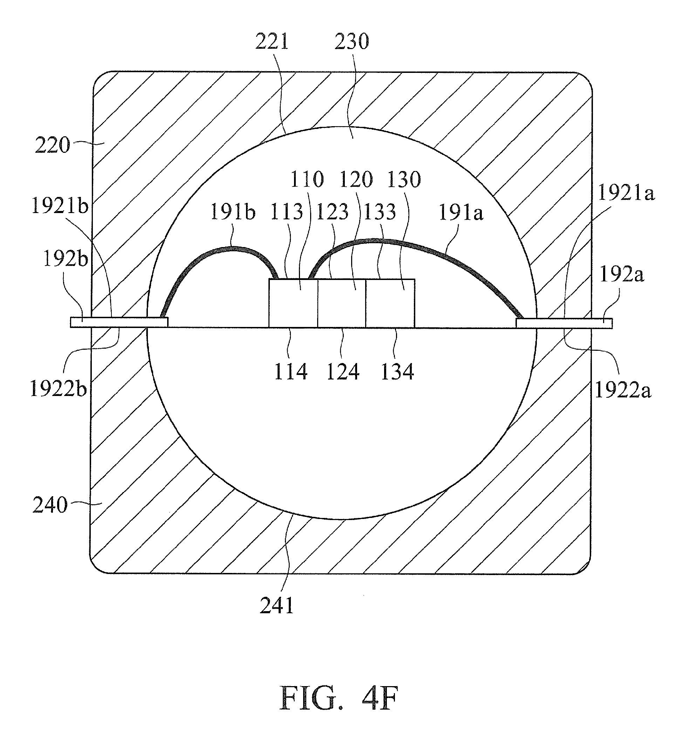

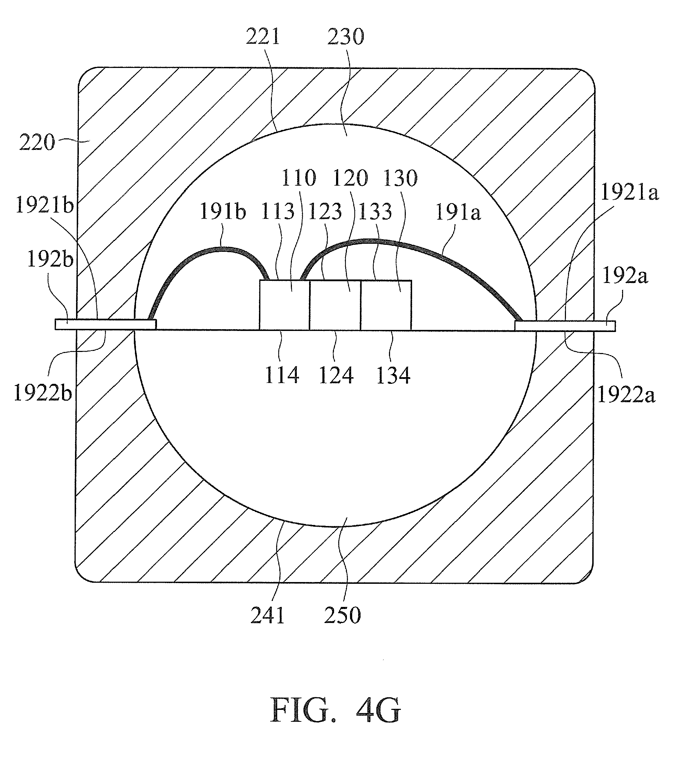

Afterwards, as shown in FIG. 4F (the conductive structures 190c-190f are not shown in FIG. 4F), a second mold 240 is provided on the first mold 210. The second mold 240 has a second mold cavity 241. The bottom surfaces 114, 124, and 134 of the light-emitting chips 110, 120, and 130 and the bottom surfaces 1922a and 1922b of the conductive structures 192a and 192b are covered by the second mold cavity 241. Afterwards, as shown in FIG. 4G (the conductive structures 190c-190f are not shown in FIG. 4G), a second encapsulant material 250 is injected into the second mold cavity 241. Therefore, the light-emitting chips 110, 120, and 130, the conductive wires 191a and 191b, and a portion of each of the conductive structures 192a and 192b are packaged by the second encapsulant material 250.

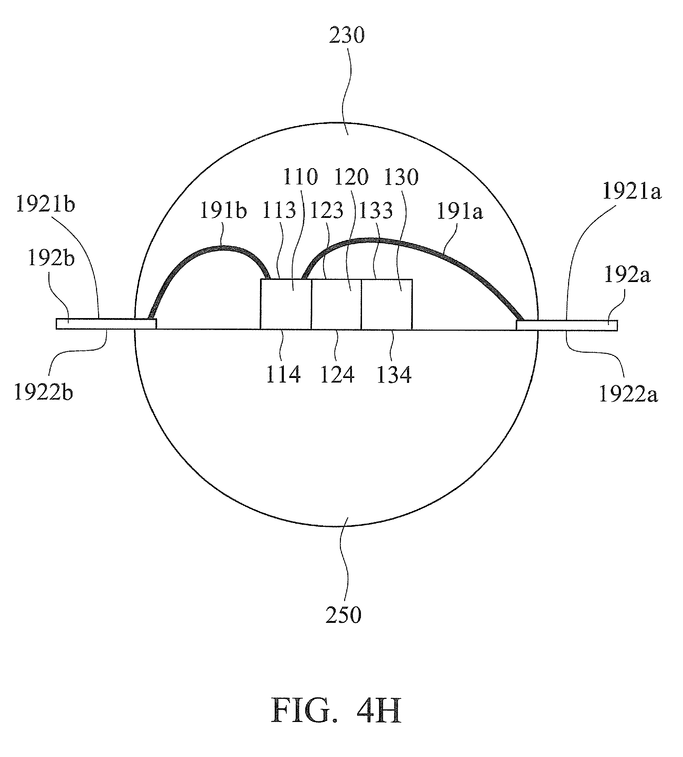

Afterwards, the first encapsulant material 230 and the second encapsulant material 250 are baked, so that the first encapsulant material 230 and the second encapsulant material 250 are cured. After the baking process, the first mold 220 and the second mold 240 are removed. The manufacturing process of the first semi-spherical package member 230 and the second semi-spherical package member 250 is completed. At this time, a spherical package member is cooperatively formed by the first semi-spherical package member 230 and the second semi-spherical package member 250, as shown in FIG. 4H.

It should be noted that the light-emitting chips 110, 120, and 130, the conductive wires 191 a and 191b, and a portion of each of the conductive structures 192a and 192b are entirely packaged by the spherical package member. Additionally, the other portion of each of the conductive structures 192a and 192b are exposed the exterior of the first semi-spherical package member 230 and the second semi-spherical package member 250 for electric connection to an external circuit.

The omnidirectional lighting unit of the disclosure includes a spherical package member for packaging the light-emitting chips. Light from the light-emitting chips is radiated via the entire outer surface of the spherical package member. Therefore, the light angle and the light uniformity of the omnidirectional lighting unit are better than that of the conventional light emitting package structure.

While the invention has been described by way of example and in terms of preferred embodiment, it is to be understood that the invention is not limited thereto. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. An omnidirectional lighting unit (100), comprising:
a light-emitting chip (110) having a positive electrode (111) and a negative electrode (112);
a spherical package member (150) encapsulating the light-emitting chip (110);
a diffusion layer (160) covering the outer surface of the spherical package member (150); and
two conductive structures (140a, 140b), respectively electrically connected to the positive electrode (111) and the negative electrode (112), wherein each of the two conductive structures (140a, 140b) outwardly penetrates through the spherical package member (150) and the diffusion layer (160), and a portion of each conductive structure (140a, 140b) is exposed to the exterior of the diffusion layer (160).

2. The omnidirectional lighting unit as claimed in claim 1, wherein each of the two conductive structures (190a, 190b) comprises a conducting wire (191 a, 191b) and a conductive terminal (192a, 192b) connected to the conducting wire (191a, 191b), wherein the conducting wires (191 a, 191 b) are electrically connected to the light-emitting chip (110), and the conductive terminals (192a, 192b) outwardly penetrate through the spherical package member (150) and the diffusion layer (160), and a portion of each conductive terminal (192a, 192b) is exposed to the exterior of the diffusion layer (160).

3. The omnidirectional lighting unit as claimed in claim 1, wherein the two conductive structures (140a, 140b) are conducting wires.

4. The omnidirectional lighting unit as claimed in claim 1, further comprising a wavelength conversion layer (170) covering the outer surface of the diffusion layer (160).

5. The omnidirectional lighting unit as claimed in claim 4, further comprising a protection layer (180) covering the outer surface of the wavelength conversion layer (170).

6. The omnidirectional lighting unit as claimed in claim 5, wherein the protection layer (180) comprises at least two regions (181, 182) with different refractive indexes.

7. The omnidirectional lighting unit as claimed in any one of claims 1 to 6, wherein the light-emitting chip (110) is an LED chip.

8. The omnidirectional lighting unit as claimed in any one of claims 1 to 7, wherein the diffusion layer (160) further comprises light diffusion particles (161).

9. The omnidirectional lighting unit as claimed in any one of claims 1 to 8, wherein the spherical package member (150) is made of materials selected from a group comprising silicon dioxide and titanium dioxide.

10. A lighting device (300), comprising:
N omnidirectional lighting units (100) as claimed in any one of claims 1 to 9, wherein N is a natural number greater than or equal to 2; and
N-1 connectors (310), wherein each of the connectors (310) is respectively between the omnidirectional lighting units (100) and electrically connected to two of the omnidirectional lighting units (100) neighboring to thereof.

11. A method for manufacturing an omnidirectional lighting unit, comprising:
providing a light-emitting chip (100) with a positive electrode (111) and a negative electrode (112);
forming two conductive structures (140a, 140b) on the light-emitting chip (100), wherein the two conductive structures (140a, 140b) are respectively electrically connected to the positive electrode (111) and the negative electrode (112);
forming a first semi-spherical package member (230) to encapsulate the upper surface (113) of the light-emitting chip (110) and a portion of the upper surface of the two conductive structures (140a, 140b); and
forming a second semi-spherical package member (250) to encapsulate the lower surface (114) of the light-emitting chip (110) and a portion of the lower surface of the two conductive structures (140a, 140b) so as to cooperatively form a spherical package member (150) with the first semi-spherical package member (230).

12. The method as claimed in claim 11, further comprising forming a diffusion layer (160) to cover the outer surface of the spherical package member (150).

13. The method as claimed in claim 12, further comprising forming a wavelength conversion layer (170) to cover the outer surface of the diffusion layer (160).

14. The method as claimed in claim 13, further comprising forming a protection layer (180) to cover the outer surface of the wavelength conversion layer (170).

15. The method as claimed in any one of claims 11 to 14, wherein the operation of forming the first and second semi-spherical package members (230, 250) comprises:
providing a carrier (210) to support the light-emitting chip (110);
providing a first mold (220) arranging on the carrier (210), wherein the first mold (220) has a first mold cavity (221) which covers the upper surface (113) of the light-emitting chip (110) and a portion of the upper surface of each conductive structure (140a, 140b) therein;
injecting a first encapsulant material (230) into the first mold (220) cavity;
removing the carrier (210);
providing a second mold (240), wherein the second mold (240) has a second mold cavity (241) which covers the lower surface (114) of the light-emitting chip (110) and a portion of the lower surface of each conductive structure (140a, 140b) therein;
injecting a second encapsulant material (250) into the second mold cavity (241);
curing the first encapsulant material (230) and the second encapsulant material (250); and
removing the first mold (220) and the second mold (240) to complete the first and second semi-spherical package members.
